# FASCICULE DE BREVET EUROPEEN

(11) **EP 0 944 134 B1**
(45) Date de publication et mention de la délivrance du brevet: **12.07.2006**
(21) Numéro de dépôt: 99410013.9
(22) Date de dépôt: 04.03.1999
(51) Int. Cl.: H01R 9/28, G01R 31/28

(54) **Elément permettant la réalisation des montages d'essais électriques ou électroniques**
Bauteil zur Herstellung einer elektrischen oder elektronischen Prüfungsvorrichtung
Component for making an electric or electronic testing device

(30) Priorité: 19.03.1998 FR 9803630
(43) Date de publication de la demande: 22.09.1999
(73) Titulaire: Cassagne, Gilles, 73470 Novalaise (FR)
(72) Inventeur: Cassagne, Gilles, 73470 Novalaise (FR)
(74) Mandataire: Hecké, Gérard

(56) Documents cités:
- WO-A-97/19499
- FR-A- 1 532 325
- FR-E- 70 438

## Description

La présente invention concerne un élément permettant la réalisation de montages d'essais électriques ou électroniques.

Notamment, du document FR1-532325 il est connu une boîte à connections électriques pour expérimentation, cette boîte comporte également un élément permettant la réalisation de montages d'essais électriques qui comporte un composant électriques et une borne de connexion.

De tels montages d'essais sont traditionnellement effectués sur des plaques à essais de différents types, telles que des plaques dites « à souder», « à wrapper », à « circuit intégré », « à fiches ».

Ces plaques ont pour inconvénients d'être peu souples à utiliser et d'impliquer une mise en place très longue des différents composants sur elles.

La présente invention vise à remédier à ces inconvénients.

A cette fin, l'élément qu'elle concerne comprend :
- un composant électrique ou électronique, ou un groupe de tels composants reliés électriquement ou électroniquement les uns aux autres,
- Des bornes de connexion, reliées électriquement aux extrémités du composant ou du groupe de composants, chacune de ces bornes comprenant une ou plusieurs fentes débouchant dans l'un de ses bords, pouvant recevoir et retenir un ou plusieurs fils conducteurs de manière à établir une connexion électrique,
- une plaque comprenant au moins deux filaments conducteurs intégrés à elle et des évidements aménagés au niveau des extrémités de ces filaments, et
- un support de matière isolante, auquel sont solidarisés ledit composant ou groupe de composants, ladite plaque et lesdites bornes.

Ce support de matière isolante permet de manipuler aisément et sans risque de détérioration un composant électrique ou électronique, ou un groupe de tels composants. Les bornes de connexion qui sont reliées à un composant électrique ou électronique, ou un groupe de tels composants permettent de connecter facilement et rapidement, par simple insertion d'un ou plusieurs fils conducteurs dans les fentes qu'elles comprennent, ce composant ou groupe de composants à d'autres éléments similaires comprenant d'autres composants ou groupe de composants.

Des éléments selon l'invention peuvent ainsi être facilement et rapidement connectés ou séparés, pour permettre la réalisation successive de différents types de montages, ou pour modifier un montage existant, au gré de l'utilisateur.

En outre, la réalisation d'un montage d'après un schéma, provenant par exemple d'une revue d'électricité ou d'électronique, est facilitée puisque l'on peut conserver la disposition des composants dans l'espace.

De préférence, chaque borne se présente sous la forme d'une lamelle métallique. Les bords de cette lamelle qui délimitent la fente ou les fentes sont relativement tranchants et permettent ainsi d'insérer un fil conducteur non dénudé dans une des fentes, lesdits bords venant sectionner la gaine lors de cette insertion pour réaliser la connexion électrique.

Avantageusement, chaque borne comprend une ou plusieurs encoches sensiblement en forme de V ou de W, dans le fond desquelles débouche une extrémité de la fente. Cette encoche constitue ainsi une entrée facilitant l'insertion du fil conducteur dans la fente.

De préférence, chaque élément comporte des indications, imprimées sur le support de matière isolante, facilitant le repérage, le rangement, la connexion des composants polarisés, des transistors ou autres. En outre, ce support peut avoir une teinte particulière constituant en elle-même une information relative aux composants qu'il comporte, en particulier en ce qui concerne le type de composants (résistances, condensateurs, fiches, etc.). Le repérage et le rangement des différents éléments sont ainsi facilités.

De préférence, chaque élément comporte des ergots permettant son assemblage sur un plateau (par exemple une plaque en plexiglas) percé au diamètre desdits ergots et selon leur espacement.

Selon une forme de réalisation de l'invention, le composant ou groupe de composants est préalablement disposé sur une plaque comprenant au moins deux filaments conducteurs intégrés à elle et des évidements aménagés au niveau des extrémités de ces filaments, permettant la soudure des extrémités du composant ou groupe de composants et des bornes créant une liaison électrique entre le composant ou groupe de composant et les bornes. La plaque, les extrémités du composant ou du groupe de composants et les parties inférieures des bornes reliées à celles-ci sont ensuite noyés dans un support de matière synthétique, laissant libre les parties supérieures des bornes comprenant lesdites fentes.

Pour sa bonne compréhension l'invention est à nouveau décrite ci-après, en se référant aux figures représentant, à titre d'exemple non limitatif, un élément qu'elle concerne,
Les figures 1A et 1B représentent une vue de la borne de connexion (4) d'un élément (1), avant fabrication de cet élément ;
les figures 2A et 2B représentent une vue en perspective d'une plaque (9) et des filaments conducteurs (10), avant fabrication dudit élément.
Les figures 3 et 4 représentent un élément (1) permettant la réalisation de montages d'essais électriques ou électroniques.

Selon l'invention l'élément (1) comporte une plaque (9) comprenant des filaments conducteurs (10) intégrés à ladite plaque et des évidements (11) sont aménagées au niveau des extrémités de ces filaments (10), dans la plaque (9), pour permettre la soudure des pattes (7) des bornes (4) de connections et des extrémités (3) d'une résistance (2), créant ainsi une liaison électrique entre lesdites pattes et la dite résistance.

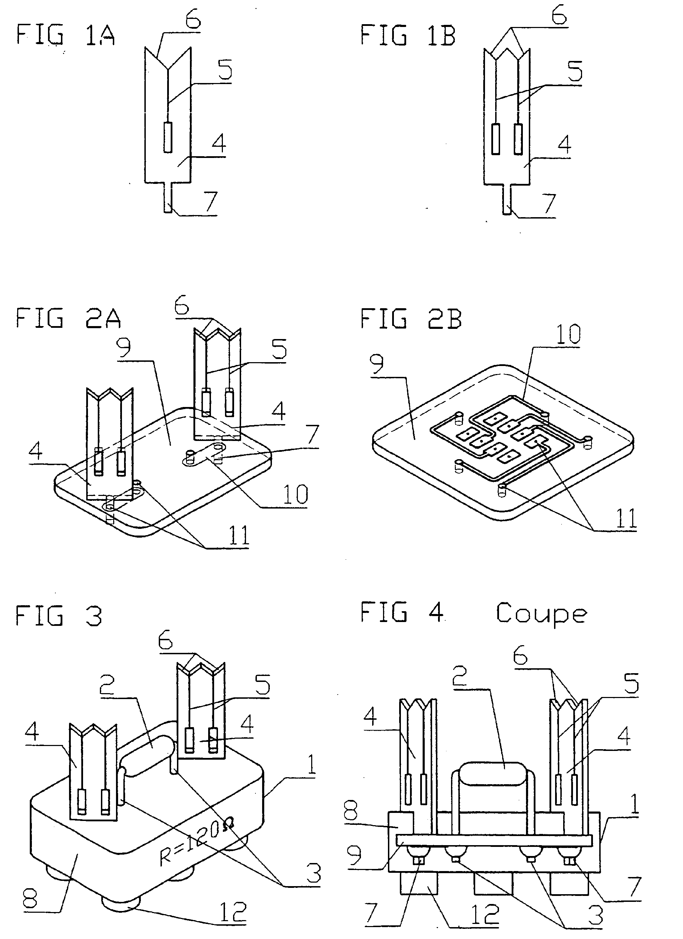

Chaque borne (4) est constituée par une lamelle métallique. Ainsi que cela est plus particulièrement visible sur la figure 1A et 1B, elle comprend une ou plusieurs fentes (5) débouchant dans l'un de ses bords longitudinaux, et une ou plusieurs encoches supérieures (6) en forme de V ou W, dans le fond desquelles débouchent les extrémités des fentes (5). Dans sa partie opposée à l'encoche (6), la borne (4) comprend une patte (7) permettant l'insertion dans les évidements (11) de la plaque (9) et la soudure sur les filaments conducteurs (10).

Comme montré aux figures 3 et 4, les extrémités (3) de la résistance (2), les pattes (7) des bornes (4) et la plaque (9) à laquelle elles sont soudées, sont noyés dans un support (8). Ce support (8) est en matière isolante, notamment une résine synthétique moulée. De plus ce support (8) comprends des ergots (12) permettant l'assemblage de l'élément (1) sur un plateau non représenté.

Chaque fente (5) est propre à recevoir un ou plusieurs fils conducteurs (non représentés) en elle, par insertion en force. Les bords de la borne (4) qui délimitent cette fente (5) sont relativement tranchants et permettant ainsi de sectionner la gaine isolante du fil conducteur.

Cette fente (5) permet ainsi de recevoir et de retenir un fil conducteur, de manière à établir facilement et rapidement une connexion électrique de la résistance (2) avec d'autres éléments comprenant d'autres composants ou groupes de composants. L'encoche (6) constitue une entrée qui facilite l'introduction d'un ou plusieurs fils conducteurs dans la fente (5).

L'élément (1) selon l'invention peut être aisément manipulé, sans risque de détérioration de la résistance (2), de sorte qu'un montage d'essais peut être facilement constitué ou démonté, pour réaliser successivement différents types de montages ou pour modifier ces montages, au gré de l'utilisateur.

## Revendications

1. Elément (1) permettant la réalisation de montages d'essais électriques ou électroniques comportant en
- un composant électrique ou électronique (2), ou un groupe de tels composants reliés électriquement ou électroniquement les uns aux autres,
- des bornes de connexion (4), reliées électriquement aux extrémités (3) du composant (2) ou groupe de composants, **caractérisé en que**
- chacune de ces bornes (4) comprend une fente (5) débouchant dans l'un de ses bords, pouvant recevoir et retenir un ou plusieurs fils conducteurs de manière à établir une connexion électrique,
- une plaque (9) comprenant au moins deux filaments conducteurs (10) intégrés à ladite plaque et des évidements (11) aménagés au niveau des extrémités desdits filaments, permettant la soudure des extrémités (3) du composant (2) ou groupe de composants et des bornes (4), et
- un support (8) en matière isolante, auquel sont solidarisés ledit composant ou groupe de composants, ladite plaque et lesdites bornes.

2. Elément selon la revendication 1, **caractérisé en ce que** chaque borne (4) se présente sous la forme d'une lamelle métallique comprenant une ou plusieurs encoches (6) sensiblement en forme de V ou de W, dans le fond desquelles débouche les extrémités des fentes (5).

3. Elément selon l'une quelconque des revendications 1 à 3, **caractérisé en ce que** le support en matière isolante comprend des ergots d'assemblage (12) et est constitué d'un bloc en matière synthétique moulée, noyant les extrémités (3) du composant (2) ou groupe de composants et les parties inférieures des bornes (4) reliées à celles-ci, et laissant libre les parties supérieures des bornes (4) comprenant lesdites fentes.

## Claims

1. An element (1) enabling electrical or electronic test assemblies to be achieved comprising:
- an electrical or electronic component (2), or a group of such components electrically or electronically connected to one another,
- connection terminals (4) electrically connected to the ends (3) of the component (2) or group of components,
**characterized in that** each of these terminals (4) comprises a slot (5) opening out into one of its edges, able to receive and secure one or more conducting wires so as to establish an electrical connection,
- a plate (9) comprising at least two conducting filaments (10) integrated in said plate and recesses (11) arranged at the level of the ends of said filaments enabling the ends (3) of the component (2) or group of components and the terminals (4) to be soldered, and
- a support (8) made of insulating material, to which support said component or group of components, said plate and said terminals are secured.

2. The element according to claim 1, **characterized in that** each terminal (4) is presented in the form of a metal blade comprising one or more appreciably V-shaped or W-shaped notches (6), the ends of the slots (5) opening out into the bottom of these notches.

3. The element according to one of the previous claims 1 and 2, **characterized in that** the support made of insulating material comprises assembly pins (12) and is formed by a block of molded synthetic material, in which the ends (3) of the component (2) or group of components and the lower parts of the terminals (4) connected thereto are sunk, and leaving the upper parts of the terminals (4) comprising said slots free.

## Patentansprüche

1. Element (1), das es erlaubt elektrische oder elektronische Versuchsanordnungen zu realisieren, welches umfasst:
- eine elektrische oder elektronische Komponente (2), oder eine Gruppe solcher Komponenten, die elektrisch oder elektronisch miteinander verbunden sind,
- Verbindungsanschlüsse (4), die elektrisch mit den Enden (3) der Komponente (2) oder der Gruppe von Komponenten verbunden sind,
**dadurch gekennzeichnet, dass** jeder dieser Anschlüsse (4) einen Spalt (5) umfasst, der in einen seiner Ränder mündet und einen oder mehrere leitende Drähte empfangen und halten kann, so dass eine elektrische Verbindung hergestellt wird,
- eine Platte (9), die mindestens zwei leitende Filamente (10) umfasst, die in der genannten Platte integriert sind, und Aussparungen (11) umfasst, die auf der Höhe der Enden der genannten Filamente angeordnet sind, und die das Verlöten der Enden (3) der Komponenten (2) oder der Gruppe von Komponenten und der Anschlüsse (4) ermöglicht, und
- einen Träger (8) aus isolierendem Material, an dem die genannten Komponenten oder die Gruppe von Komponenten, die genannte Platte und die genannten Anschlüsse befestigt sind.

2. Element gemäß Anspruch 1, **dadurch gekennzeichnet, dass** jeder Anschluss (4) die Form eines Metallblättchens hat, das eine oder mehrere in etwa V- oder W-förmige Kerben (6) hat, wobei die Enden der Spalte (5) in den Boden dieser Kerben münden.

3. Element gemäß einem der Ansprüche 1 und 2, **dadurch gekennzeichnet, dass** der Träger aus isolierendem Material Aufbaunocken (12) umfasst und aus einem Block aus gussgeformten synthetischen Material gebildet ist, in welches die Enden (3) der Komponenten (2) oder der Gruppe von Komponenten und die unteren Teile der daran verbundenen Anschlüsse (4) versenkt sind, wobei die oberen Teile der Anschlüsse (4), die die genannten Spalte umfassen, frei gehalten sind.
